# EUROPEAN PATENT SPECIFICATION

(11) **EP 0 455 915 B1**
(45) Date of publication and mention of the grant of the patent: **14.12.1994**
(21) Application number: 90314246.1
(22) Date of filing: 24.12.1990
(51) Int. Cl.: C23C 18/18, C23C 18/30

(54) **Electroless plating of nickel onto surfaces such as copper or fused tungsten**
Stromlose Abscheidung von Nickel auf Oberflächen wie Kupfer oder geschmolzenem Wolfram
Dépôt chimique de nickel sur des surfaces telles que le cuivre ou le tungstène fondu

(30) Priority: 08.05.1990 US 520635
(43) Date of publication of application: 13.11.1991
(73) Proprietor: MACDERMID INCORPORATED, Waterbury, Connecticut 06702 (US)
(72) Inventor: Bengston, Jon E., Newington, Connecticut 06111 (US)
(74) Representative: Pendlebury, Anthony

(56) References cited:
- EP-A- 0 260 516
- PATENT ABSTRACTS OF JAPAN, vol. 7, no. 281 (C-200)[1426], 15th December 1983; & JP-A-58 161 760

## Description

The present invention relates to electroless nickel plating, more particularly to the electroless nickel plating of surfaces such as copper or fused tungsten, and still more particularly to the activation of, e.g., copper or fused tungsten surfaces for receipt of electroless nickel.

In many applications of the fabrication of printed circuits having conductive copper circuity paths and areas, as well as in applications of fused tungsten circuitry on ceramic substrates, electroless nickel is desired to be plated over the copper or over the fused tungsten. In printed circuits, for example, electroless nickel plating over copper is often used to form a diffusion barrier for a subsequently-applied gold plating, while in tungsten circuitry electroless nickel plating is used, e.g., to provide more readily solderable surfaces.

A wide variety of electroless nickel plating baths are available, comprised generally of aqueous solutions containing a source of nickel ions, a reducing agent for the nickel and a complexing agent, capable of operating over predetermined ranges of pH, with the most common such baths being based upon hypophosphite reducing agents. In order to electrolessly plate nickel from such baths onto copper surfaces (e.g., in printed circuit boards), it is necessary to first activate the copper surfaces. The most common means for effecting this activation is by contact of the copper surfaces with species catalytic to deposition, typically colloidal sols or solutions of palladium-tin (see, e.g., the one-step catalyst compositions of U.S. Patent Nos. 3,011,920 and 3,532,518, requiring an acceleration step, and the one-step catalyst compositions of U.S. Patent No. 4,863,758, which do not require acceleration). This same method is used to activate tungsten circuitry surfaces for subsequent electroless nickel plating.

For copper surfaces, it is also known to activate them by application of a prestrike layer of nickel from an electroless bath utilizing a boron compound, e.g., dimethyl amine borane or borohydride, as the reducing agent, which prestrike layer then serves to catalyze electroless nickel deposition from a more conventional bath (e.g., hypophosphite-reduced).

The palladium-based activators for electroless nickel plating of copper or fused tungsten surfaces are relatively expensive and must be maintained at carefully controlled concentrations in order to be effective. More problematic is the fact that for printed circuits having copper surfaces which are to be activated for electroless plating in this manner, the procedure involves immersion of the entire circuit board, including insulating areas, into the palladium-containing sol or solution. Although post-rinsing procedures are employed, the catalytic species may nevertheless become entrapped into insulating areas, and will there catalyze electroless nickel plating when the board is immersed in an electroless nickel bath. The resultant unwanted areas or paths of metal on the insulating areas can lead to undesirable cross-talk or shorting between conductive circuitry on the board. This same problem occurs with tungsten-ceramic packages, i.e., the palladium-based activator can become entrapped or adhered to insulating ceramic surfaces and promote undesired metallization thereof.

The same problem occurs with the prestrike method of activation for copper surfaces i.e., the very activity of the borane or borohydride-reduced electroless nickel bath which enables it to deposit a strike layer of nickel over the copper also can result in undesired deposition of nickel on insulating areas of theboard. Also in common with the palladium-based activators, these nickel strike baths are relatively expensive and their composition must be carefully controlled to avoid spontaneous plating of all metal in the solution.

The present invention aims to provide a process for depositing an electroless nickel layer onto copper or fused tungsten surfaces, particularly on copper or fused tungsten circuitry in printed circuit boards and integrated circuits without need for expensive activators for the surfaces and in a manner which minimizes and/or eliminates deposition of nickel on surfaces which are to remain non-metallized.

According to the present invention there is provided a process for providing an electroless plating comprised of nickel on particular exposed conductive surfaces of a substrate additionally containing exposed surfaces where nickel plating is not desired, wherein said exposed conductive surfaces are activated for receipt of electroless nickel plating and then contacted with an electroless nickel plating bath, characterised in that the said exposed conductive surfaces are activated by non-selectively contacting the substrate with a composition comprising particulate zinc metal suspended in a carrier liquid, the non-selective contacting being for a time sufficient to provide on the exposed conductive surfaces a sufficient quantity of zinc particles such that, upon subsequent non-selective contacting of the substrate with the electroless nickel plating bath, deposition of nickel from the nickel plating bath selectively occurs on the exposed conductive surfaces and not on the exposed surfaces of the substrate where nickel plating is not desired.

According to the process of the invention copper or fused tungsten surfaces to be electrolessly nickel plated are contacted with a composition comprised of particulate zinc metal suspended in a liquid carrier, so as to activate the surfaces to the electroless nickel deposition. Activation is achieved without need for palladium-based catalysts or nickel prestrike from solutions using boron-based reducing agents.

Among the significant advantages of the invention is the ability to activate copper or fused tungsten surfaces for subsequent electroless nickel deposition utilizing relatively low cost compositions which do not require the attention to controlled concentrations of components as is the case for palladium-based activators and boron-based prestrike activators.

Another significant advantage of the invention is that the activating composition and process are such that the activation is selective to the copper or fused tungsten surfaces relative to insulating areas where no electroless nickel deposition is required. In the process of the invention, the work object (e.g., a printed circuit board having a predetermined copper circuitry pattern and insulating substrate areas, or a tungsten-ceramic package having a defined pattern of tungsten circuitry on a ceramic substrate) is immersed in the zinc particle suspension for a time sufficient to permit zinc particles to become entrapped or attached to the copper surfaces, and in this immersion zinc particles also will likely become entrapped or attached to insulating areas of the board or package. When the board or package is then immersed in a conventional acid or alkaline electroless nickel plating bath, the zinc particles dissolve in the bath and, during the dissolution, a cathodic current is produced in reference to the copper or tungsten surface, resulting in deposition of nickel on the copper or tungsten areas. Once nickel has been deposited in this manner, electroless deposition of nickel from the bath continues thereon, essentially being autocatalyzed by the nickel seed produced by the zinc dissolution effect. At the same time, the zinc particles present on insulating surfaces undergo the same dissolution in the electroless nickel bath, but the dissolution is unaccompanied by cathodic current since no copper or tungsten is there present. Hence, no nickel deposition will occur, and any zinc particles on insulating areas will simply dissolve in the bath.

The fundamental objective of the inventive process, as applied to its preferred aspects, is to deposit (e.g., entrap, attach, etc.) particulate zinc metal onto copper or tungsten surfaces so as to activate those surfaces to subsequent electroless nickel depositing. In the most preferred embodiment of the invention, this objective is attained by contact of those surfaces with a composition comprised of particulate zinc metal suspended in a carrier liquid, the contact being for a period of time effective to entrap or attach a sufficient quantity of zinc particles from the suspension onto the copper or tungsten surfaces.

For compatibility with overall processing steps and the subsequent electroless nickel baths, the carrier liquid of choice for the particulate zinc almost invariably will be water. In its simplest form of execution, the activating composition will consist of particulate zinc metal in water, and immersion therein of the surfaces to be activated will generally be accompanied by agitation or mixing of the composition to maintain the zinc particles in a generally uniform suspension in the water so as to avoid settling of the zinc particles and to achieve relatively uniform contact of the surfaces in question with zinc particles.

Typically, the particulate zinc metal in the activating composition will have a particle size on the order of less than about 50 µm (microns), more preferably an average particle size of from about 1 to about 20 µm (microns), and most preferably a particle size in the range of from about 5 to 7 µm (microns).

The concentration of particulate zinc in the composition can vary within relatively wide limits, depending for example on the extent of copper or tungsten surface to be activated. Generally speaking, activation can be accomplished using as little as 0.1 grams per liter particulate zinc in the composition, but more practical compositions generally will contain at least about 1 g/l particulate zinc, and most preferably at least about 3 g/l particulate zinc. Upper limits are generally dictated by practical considerations, e.g., the ability to maintain a particular concentration of zinc particles in generally uniform suspension for use. Typically speaking, practical upper limits are on the order of 50 g/l, more preferably on the order of 30 g/l. Particularly useful ranges for the concentration of particulate zinc in the activating composition will be about 3 to about 10 grams per liter.

The basic components of the composition, i.e., particulate zinc metal and liquid carrier (water), also can be advantageously supplemented with additional components. Thus, for example, a source of alkalinity can be included in the composition, for example, as by alkali or alkaline earth metal or ammonium hydroxides, carbonates, and the like or other suitable composition-compatible compounds, in order to minimize corrosive attack on the zinc particles in the composition. Typically, the source of alkalinity is such as to achieve a composition pH of at least about 8, and preferably between about 8 and 11, and the compounds used to this end typically will be present in the composition at a concentration of from about 0.1 to about 2 g/l, more preferably from about 0.1 to about 1 g/l.

The composition also can utilize to advantage components which aid in maintaining an aqueous suspension of the zinc particles. Such components broadly include surfactants (wetting agents) and/or thickening agents (e.g., gelatin, hydrophilic colloids, and the like, as well as certain wetting agents). The presence of these components typically will be at relatively low concentrations effective to bring about the desired result of promoting and maintaining uniform suspension of zinc particles in the composition, and will, of course, vary depending upon the particular type of component used. Obviously, these components are utilized at concentrations below those which would increase the composition viscosity so substantially as to render the composition unusable in an immersion process, but apart from that criterion the range of concentration is quite broad and easily ascertainable for particular components, concentration of zinc particles in the composition, and other like factors. As to the surfactants, generally any cationic, anionic or nonionic surfactant can be employed, including for example fluorocarbon surfactants (FC 98 anionic, FC 99 anionic, FC 170C nonionic, available from 3M Corporation), sulfonic acid and/or sulfonate surfactants (Daxad 11 anionic, available from W. R. Grace & Co.; Cetats cationic, available from Hexcel), phosphate surfactants (Triton H-66 anionic, available from Rohm & Haas; Jordaphos JB-40 anionic, available from Jordan Chemical Co.), and nonionic ethoxylated alcohols and fatty acids (Triton X-100, Rohm & Haas; ENC 5540, Chemax).

Any component added to the fundamental components for the composition must, of course, be compatible with (i.e., not interfere with) the fundamental functionality of the zinc particles in activating the copper or tungsten surfaces for electroless nickel deposition. Such interference can come about, for example, where the surfactant contains compounds which exert strong surface passivating effects, as is the case, for example, with iodides or iodates which are found in certain otherwise suitable surfactants.

In terms of the process of the invention, the contact of the copper or tungsten surfaces with the activating composition (e.g., by immersion of the printed circuit board or fused tungsten-ceramic package into the composition) is preferably carried out at a composition temperature of about room temperature, although higher and lower temperatures can of course be employed. The contact time is merely that sufficient to entrap or attach a sufficient quantity of zinc particles to the surfaces to be activated so as to enable the surfaces to receive a nickel coating from an electroless nickel bath, and can vary widely depending upon the concentration of zinc particles in the composition, the extent of the areas to be activated, and the like. Typically, contact times on the order of as little as thirty seconds will be sufficient for most applications, while two minutes contact time is a more preferred and practical period.

After contact with the composition, the surfaces contacted typically should be water rinsed to remove residual wetting or thickening agents, etc. which might have been employed in the composition, as well as zinc particles which have not adhered to the surfaces. Thereafter, the electroless nickel plating is carried out in conventional manner for the period necessary to deposit the desired thickness of electroless nickel.

The invention in its preferred environment is broadly applicable to any situation where it is desired to electrolessly nickel plate copper or tungsten, but as previously noted finds its most practical applicability in the electroless nickel plating of all or predetermined areas of conductive copper circuitry on printed circuit boards and/or all or predetermined areas of fused tungsten circuitry in fused tungsten-ceramic components.

Although described herein with reference to the preferred copper or tungsten surfaces which represent immediately practical applications of the invention, the broad process per se has applicability to the electroless nickel plating of any conductive surface which is amenable to the cathodic current generating mechanism associated with dissolution of zinc particles in the electroless nickel bath at those surfaces, and more particular applicability to situations where the conductive surfaces to be electrolessly nickel plated are on a substrate having exposed non-conductive areas on which nickel deposition is not required. For example, the invention has applicability to providing an electroless nickel layer on silver and carbon conductive inks used on ceramic hybrid circuits.

Also, while the invention has been described with reference to, and is practiced with, zinc particles, possibility also exists for use of particulate magnesium metal in the same way, either alone or in combination with zinc metal particles, and according to the teachings herein regarding zinc particulates. Magnesium is less preferred than zinc for use herein primarily because, over prolonged use, it likely will result in destabilizing of the electroless nickel bath.

The following examples are provided in further illustration of the invention.

### EXAMPLE I

A fused tungsten-ceramic micro-chip holder was immersed in a stirred, room temperature aqueous suspension containing 10 g/l zinc particles (average particle size of 5 to 7 µm (microns)) and 40 g/l caustic for two minutes. Thereafter, the ceramic package was rinsed thoroughly in water, and then immersed in an acidic electroless nickel bath for twenty minutes. All tungsten circuitry was coated with nickel, and no extraneous nickel was observed on the non-tungsten areas of the ceramic insulator.

### EXAMPLE II

A printed circuit board having defined areas of copper traces was cleaned, deoxidized and rinsed, and then immersed in the zinc particle suspension of Example I such that only half the board was immersed in contact with the suspension. After thirty seconds, the entire board was water rinsed and immersed in an acidic electroless nickel bath. After five minutes, all copper traces on the board half previously immersed in the zinc suspension were coated with nickel, while the copper traces on the other board half had no nickel deposit. No nickel was observed on any of the insulating areas of the board, including those on the board half previously immersed in the zinc suspension.

### EXAMPLE III

A copper foil-clad printed circuit board substrate with through holes was treated to provide electroless copper in the through holes and over the copper foil, and was thereafter provided with a patterned resist by use of a layer of photoresist, imagewise exposure, and development. The resist-patterned board was then processed to provide electroplated copper and electroplated tin-lead layers on the non-resist surfaces, followed by stripping of the resist, etching of the previously resist-covered areas down to the insulating substrate, stripping of the previously-applied tin-lead layer, and application of solder mask over preselected areas of the circuitry. Thereafter, in order to activate the exposed copper traces and copper coated through-holes for subsequent electroless nickel plating, the board was immersed in a room temperature, stirred aqueous suspension containing 40 g/l zinc particles, 40 g/l sodium hydroxide, and 5 g/l alkyl naphthalene sulfonic acid (Daxad 11 anionic surfactant) for two minutes. The board was then water rinsed and immersed in an acidic electroless nickel plating bath whereupon the activated copper surfaces, but no other areas, received a coating of electroless nickel. The board was then rinsed, the nickel-plated areas provided with an electroless gold plate, rinsed and dried.

The foregoing is, of course, just one of may possible sequences in the fabrication of printed circuit boards, and the present invention is applicable to any fabrication method wherein electroless nickel is required to be plated onto selected copper areas.

## Claims

1. A process for providing an electroless plating comprised of nickel on particular exposed conductive surfaces of a substrate additionally containing exposed surfaces where nickel plating is not desired, wherein said exposed conductive surfaces are activated for receipt of electroless nickel plating and then contacted with an electroless nickel plating bath, characterised in that the said exposed conductive surfaces are activated by non-selectively contacting the substrate with a composition comprising particulate zinc metal suspended in a carrier liquid, the non-selective contacting being for a time sufficient to provide on the exposed conductive surfaces a sufficient quantity of zinc particles such that, upon subsequent non-selective contacting of the substrate with the electroless nickel plating bath, deposition of nickel from the nickel plating bath selectively occurs on the exposed conductive surfaces and not on the exposed surfaces of the substrate where nickel plating is not desired.

2. A process according to Claim 1, wherein the non-selective contacting of the substrate with the composition comprising particulate zinc metal, comprises immersion of the substrate in the composition, and wherein the non-selective contacting of the substrate with the electroless nickel plating bath comprises immersion of the substrate in the plating bath.

3. A process according to Claim 1, or 2, wherein the exposed conductive surfaces of the substrate to be provided with the electroless plating comprised of nickel, comprise copper or tungsten.

4. A process according to Claim 1, 2 or 3, wherein the exposed surfaces of the substrate where nickel plating is not desired comprise non-conductive surfaces.

5. A process according to any one of the preceding claims, wherein the substrate comprises a printed circuit board and wherein the exposed conductive surfaces of the substrate to be provided with the electroless plating comprised of nickel, comprise copper circuitry areas of the printed circuit board.

6. A process according to any one of Claims 1 to 4, wherein the substrate comprises a ceramic, and wherein the exposed conductive surfaces of the substrate to be provided with the electroless plating comprised of nickel, comprise fused tungsten circuitry areas on the substrate.

7. A process according to any one of the preceding claims, wherein the carrier liquid is water, and wherein the composition comprising particulate zinc further comprises a source of alkalinity sufficient to achieve a composition pH of at least about 8.

8. A process according to Claim 7, wherein the composition comprising particulate zinc further comprises an agent, selected from wetting agents, thickners and mixtures thereof, for promoting and maintaining the zinc particles in suspension in the composition.

9. An electrolessly nickel plated conductive surface obtained by the process as claimed in any one of the preceding claims.

10. A composition for activating copper and/or tungsten surfaces for receipt thereon of electroless nickel, the composition consisting essentially of an aqueous admixture of particulate zinc metal, a source of alkalinity sufficient to achieve a composition pH at least about 8, and one or more agents for promoting and maintaining the particulate zinc metal in suspension in the composition.

## Patentansprüche

1. Verfahren zum stromlosen Aufbringen einer Nickelbeschichtung auf besonderen freiliegenden leitenden Flächen eines Substrats, das außerdem freiliegende Flächen aufweist, auf denen eine Nickelbeschichtung nicht erwünscht ist, wobei die freiliegenden leitenden Flächen zur stromlosen Aufnahme einer Nickelbeschichtung aktiviert und sodann stromlos mit einem Nickelbeschichtungsbad kontaktiert werden, dadurch gekennzeichnet, daß die freiliegenden leitenden Flächen durch nicht-selektives Kontaktieren des Subtrats mit einer Zusammensetzung aktiviert werden, welche in einer Trägerflüssigkeit suspendiertes teilchenförmiges metallisches Zink aufweist, wobei das nicht-selektive Kontaktieren über eine ausreichende Zeit erfolgt, um auf die freiliegenden leitenden Oberflächen eine ausreichende Menge von Zinkteilchen derart aufzubringen, daß beim folgenden nicht-selektiven Kontaktieren des Substrats mit dem stromlos anzuwendenden Nickelbeschichtungsbad eine selektive Abscheidung von Nickel aus dem Nickelbeschichtungsbad auf den freiliegenden leitenden Flächen und nicht auf den freiliegenden Oberflächen des Substrats, auf denen eine Nickelbeschichtung nicht erwünscht ist, erfolgt.

2. Verfahren nach Anspruch 1, bei welchem das nicht-selektive Kontaktieren des Substrats mit der aus teilchenförmigem metallischem Zink bestehenden Zusammensetzung ein Eintauchen des Substrats in die Zusammensetzung umfaßt, und bei welchem das nicht-selektive Kontaktieren des Substrats mit dem stromlos anzuwendenden Nickelbeschichtungsbad ein Eintauchen des Substrats in das Beschichtungsbad umfaßt.

3. Verfahren nach Anspruch 1 oder 2, bei welchem die freiliegenden leitenden Oberflächen des Substrats, die mit der stromlos aufzubringenden Nickelbeschichtung zu versehen sind, aus Kupfer oder Wolfram bestehen.

4. Verfahren nach Anspruch 1, 2 oder 3, bei welchem die freiliegenden Oberflächen des Substrats, auf denen eine Nickelbeschichtung nicht erwünscht ist, aus nicht-leitenden Oberflächen bestehen.

5. Verfahren nach einem der vorangehenden Ansprüche, bei welchem das Substrat aus einem gedruckten Schaltungsplättchen besteht und bei welchem die freiliegenden leitenden Oberflächen des Substrats, die mit der stromlos aufzubringenden Nickelbeschichtung zu versehen sind, aus Kupfer-Schaltungsbereichen des gedruckten Schaltungsplättchens bestehen.

6. Verfahren nach einem der Ansprüche 1 bis 4, bei welchem das Substrat ein Keramikmaterial aufweist, und bei welchem die freiliegenden leitenden Oberflächen des Substrats, die mit der stromlos aufzubringenden Nickelbeschichtung zu versehen sind, aus Schaltungsbereichen von geschmolzenem Wolfram auf dem Substrat bestehen.

7. Verfahren nach einem der vorangehenden Ansprüche, bei welchem die Trägerflüssigkeit Wasser ist und bei welchem die teilchenförmiges Zink aufweisende Zusammensetzung ferner eine Quelle von Basizität enthält, welche ausreicht, um einen pH-Wert der Zusammensetzung von mindestens etwa 8 zu erzielen.

8. Verfahren nach Anspruch 7, bei welchen die teilchenförmiges Zink enthaltende Zusammensetzung ferner ein Mittel enthält, das ausgewählt ist aus Benetzungsmitteln, Eindickmitteln und Mischungen derselben, um die Zinkteilchen in der Zusammensetzung in Suspension zu bringen und zu halten.

9. Stromlos mit Nickel beschichtete leitende Oberfläche, die durch das Verfahren nach einem der vorangehenden Ansprüche hergestellt ist.

10. Zusammensetzung zum Aktivieren von Kupfer- und/oder Wolfram-Oberflächen, um auf diesen stromlos eine Nickelbeschichtung zu erhalten, wobei die Zusammensetzung im wesentlichen aus einer wässrigen Mischung von teilchenförmigem Zinkmetall, einer Quelle von Basizität, welche ausreicht, um einen pH-Wert der Zusammensetzung von mindestens etwa 8 zu erzielen, sowie einem oder mehreren Mitteln, um das teilchenförmige metallische Zink in der Zusammensetzung in Suspension zu bringen und zu halten, besteht.

## Revendications

1. Procédé pour fournir un dépôt chimique constitué de nickel sur des surfaces conductrices particulières exposées d'un substrat contenant en outre des surfaces exposées où le dépôt de nickel n'est pas souhaité, où lesdites surfaces conductrices exposées sont activées pour recevoir le dépôt chimique de nickel et ensuite pour être mises en contact avec le bain de dépôt chimique de nickel, caractérisé en ce que lesdites surfaces conductrices exposées sont activées par la mise en contact non sélective du substrat avec une composition comprenant le métal de zinc sous forme de particules suspendu dans un liquide porteur, la mise en contact non sélective se faisant pendant un temps suffisant pour placer sur les surfaces conductrices exposées une quantité suffisante de particules de zinc de sorte que, lors de la mise en contact non sélective suivante du substrat avec le bain de dépôt chimique de nickel, le dépôt de nickel à partir du bain de nickel se fasse sélectivement sur les surfaces conductrices exposées et non sur les surfaces exposées du substrat là où le dépôt de nickel n'est pas souhaité.

2. Procédé selon la revendication 1, où la mise en contact non sélective du substrat avec la composition comprenant du métal de zinc sous forme de particules, comprend l'immersion du substrat dans la composition, et où la mise en contact non sélective du substrat avec le bain de dépôt chimique de nickel comprend l'immersion du substrat dans le bain de dépôt.

3. Procédé selon la revendication 1 ou 2, où les surfaces conductrice exposée du substrat sur lesquelles doit être réaliser le dépôt chimique constitué de nickel, comprend du cuivre ou du tungstène.

4. Procédé selon la revendication 1,2 ou 3, où les surfaces exposées du substrat là où le dépôt de nickel n'est pas souhaité comprend des surfaces non conductrices.

5. Procédé selon une quelconque des revendications précédentes, où le substrat comprend une plaque de circuit imprimé et où les surfaces conductrices exposées du substrat sur lesquelles doit être réalisé le dépôt chimique constitué de nickel, comprennent des zones de circuit de cuivre de la plaque de circuit imprimé.

6. Procédé selon une quelconque des revendications 1 à 4, où le substrat comprend une céramique, et où les surfaces conductrices exposées du substrat sur lesquelles doit être réalisé le dépôt chimique constitué de nickel, comprennent des zones de circuit de tungstène fondu sur le substrat.

7. Procédé selon une quelconque des revendications précédentes, où le liquide porteur est l'eau, et où la composition comprenant le zinc sous forme de particules comprend en outre une source d'alcalinité suffisante pour obtenir un pH de la composition d'au moins environ 8.

8. Procédé selon la revendication 7, où la composition comprenant le zinc sous forme de particules comprend en outre un agent, sélectionné parmi les agents mouillants, les épaississeurs et leurs mélanges, pour faciliter et maintenir les particules de zinc en suspension dans la composition.

9. Surface conductrice sur laquelle a été réalisé le dépôt chimique de nickel obtenue par le procédé comme revendiqué dans une quelconque des revendications précédentes.

10. Composition pour activer les surfaces de cuivre et/ou de tungstène afin d'y recevoir du nickel par voie chimique, la composition comprenant essentiellement une adjonction en milieu aqueux de métal de zinc sous forme de particules, une source d'alcalinité suffisante pour obtenir un pH de la composition d'au moins 8, et un ou plusieurs agents afin de faciliter et de maintenir le métal de zinc sous forme de particules en suspension dans la composition.
